# EUROPÄISCHE PATENTSCHRIFT

(11) **EP 3 699 320 B1**
(45) Veröffentlichungstag und Bekanntmachung des Hinweises auf die Patenterteilung: **03.01.2024**
(21) Anmeldenummer: 19215237.9
(22) Anmeldetag: 11.12.2019
(51) Int. Cl.: C23C 16/448, C23C 16/455, B05B 7/14

(54) **DOSIERVORRICHTUNG ZUM DOSIEREN EINES PULVERFÖRMIGEN STOFFES**
DOSING DEVICE FOR DOSING A POWDERY SUBSTANCE
DISPOSITIF DE DOSAGE PERMETTANT DE DOSER UNE SUBSTANCE PULVÉRULENTE

(30) Priorität: 20.12.2018 DE 202018107303 U
(43) Veröffentlichungstag der Anmeldung: 26.08.2020
(73) Patentinhaber: Gemeinnützige KIMW Forschungs-GmbH, 58507 Lüdenscheid (DE)
(72) Erfinder: Mumme, Frank, 55425 Waldalgesheim (DE)
(74) Vertreter: Haverkamp Patentanwälte PartG mbB

(56) Entgegenhaltungen:
- EP-A1- 3 396 731
- DE-A1-102011 051 263
- US-A- 4 726 715

## Beschreibung

Die Erfindung betrifft eine Dosiervorrichtung zum Dosieren eines pulverförmigen Stoffes, insbesondere eines Precursors zum Zuführen desselben in einen CVD-Reaktor einer CVD-Anlage zum Abscheiden etwa einer metallischen Schicht auf einem Substrat, umfassend einen Vorratsbehälter zum Bevorraten des pulverförmigen Stoffes mit einem Auslauf, eine unterhalb des Auslaufes in einem Förderkanal angeordnete Förderschnecke mit einer Förderrichtung quer zur Auslaufrichtung des Vorratsbehälters zum Fördern des pulverförmigen Stoffes von dem Auslauf zu einer Mündung, an der der geförderte pulverförmige Stoff als Schwebfracht von einem an der Mündung vorbeiströmenden Trägergasstrom aufgenommen wird, und eine Trägergasversorgung mit einer an eine Trägergasquelle anschließbaren, an der Mündung des Förderkanals oder einer Verlängerung derselben vorbeigeführten und an einen CVD-Reaktor anschließbaren Trägergasleitung.

Derartige Dosiervorrichtungen werden zum Zuführen eines pulverförmigen Precursor-Stoffes, etwa zum Zuführen desselben in einen CVD-Reaktor eingesetzt. Eine solche Dosiervorrichtung ist beispielsweise aus DE 10 2011 051 263 A1 bekannt. Diese vorbekannte Dosiervorrichtung verfügt über einen Vorratsbehälter, dessen unterer Auslauf den pulverförmigen Stoff einer Förderschnecke zuführt, deren Förderrichtung quer zur Längserstreckung des Auslaufes des Vorratsbehälters verläuft. Parallel zur Längserstreckung der Förderschnecke befindet sich in dem Vorratsbehälter ein durch einen Motor angetriebenes Rührwerk, durch das der pulverförmige Stoff der Förderschnecke zugeführt wird. Die Förderschnecke ist in einem Förderkanal angeordnet. An der Mündung des Förderkanals werden die pulverförmigen Stoffpartikel von einem Trägergasstrom aufgenommen, einem Verdampfungskörper zugeführt und die Verdampfungsprodukte anschließend in einen CVD-Reaktor über einen Gasverteilerkopf eingeleitet. In dem CVD-Reaktor befindet sich dem Gasverteilungskopf gegenüberliegend ein Substrat, welches mit dem verdampften Stoff zu beschichten ist. Angeschlossen an den CVD-Reaktor ist eine Vakuumpumpe, um den für den chemischen Dampfabscheideprozess erforderlichen Unterdruck (Vakuum) in dem CVD-Reaktor zu erzeugen. Diese vorbekannte Dosiervorrichtung dient zum Fördern eines organischen Pulvers als Precursor für das aus der Dampfphase abzuscheidende Material, da in dem CVD-Reaktor OLED-Schichten auf einem Substrat abgeschieden werden sollen.

Ein Verfahren und eine Vorrichtung zur chemischen Gasphasenabscheidung dünner Schichten mit einer Dosiervorrichtung, wie vorstehend beschrieben, ist auch aus EP 0 585 848 A1 bekannt.

CVD-Verfahren werden auch zum Abscheiden von dünnen Metallschichten verwendet. Dann handelt es sich bei dem in Dampfphase befindlichen Stoff um einen solchen, der dem abzuscheidenden Metall entspricht. Herkömmlich wird zum Abscheiden von metallischen Schichten mittels chemischer Dampfabscheidung (CVD) ein Precursor in flüssiger Form eingesetzt. Dieses erfolgt vor dem Hintergrund, dass die Dosierung des Metalls in den CVD-Reaktor in Geringstmengen zu erfolgen hat und eine Flüssigdosierung von Kleinst-bzw. Geringstmengen sehr viel einfacher realisierbar und kontrollierbar ist als eine Feststoffdosierung. Nachteilig ist bei einer CVD-Anlage mit Flüssigdosierung, dass von der in den CVD-Reaktor eingebrachten und darin verdampften Flüssigkeit etwa 90% Lösemittel sind und nur 10% den eigentlichen Precursor darstellen. Bei einer Flüssigdosierung des bei einer Metallabscheidung eingesetzten Precursors ist daher der apparative Aufwand im bzw. am CVD-Reaktor beträchtlich, da ausgangsseitig am CVD-Reaktor eine aufwendige Kühlfallentechnologie vorgesehen sein muss, um das Lösemittel zurückzugewinnen. Zudem neigt der CVD-Reaktor bei einer Flüssigdosierung zu einem Verölen. Auch kann nicht ausgeschlossen werden, dass in der auf dem Substrat aufgetragenen Schicht Lösemittelpartikel mit eingeschlossen werden, was die Qualität der abgeschiedenen Schicht beeinträchtigt und daher nicht gewünscht ist.

Vor diesem Hintergrund wäre eine Feststoffdosierung eines Precursors zum Abscheiden von metallischen Schichten auf einem Substrat durch chemische Dampfabscheidung einer Flüssigkeitsdosierung vorzuziehen. Problematisch ist allerdings die Dosierung der erforderlichen Geringstmengen. Erschwerend kommt hinzu, dass der erforderliche Verdampfungsprozess der zugeführten Feststoffpartikel quasi spontan erfolgen soll und daher der pulverförmige Stoff als Precursor nur eine sehr geringe Korngröße aufweisen soll. Bei einem pulverförmigen Stoff, dessen Partikel eine Korngröße zwischen etwa 30 und 300 µm aufweisen, besteht bei der Förderung des Feststoffes das Problem, dass der pulverförmige Stoff im Vorratsbehälter sowie in der Förderschnecke kompaktiert, einem Verbacken ähnlich, wird und die Precursorzufuhr aus diesem Grunde blockiert oder jedenfalls beeinträchtigt wird. Dieses kann dazu führen, dass aus dem Auslauf des Vorratsbehälters kein Precursormaterial ausläuft oder aufgrund einer übermäßigen Kompaktion des pulverförmigen Stoffes in dem Förderkanal der Förderschnecke deren Drehbewegung blockiert. Selbst wenn aus dem Auslauf der pulverförmige Precursorstoff ausläuft und durch die Förderstrecke gefördert wird, kann aufgrund der unkontrollierbaren Kompaktion nicht gewährleistet werden, dass der pulverförmige Stoff mit einer konstant bleibenden Menge dem Trägergasstrom zugeführt wird, weshalb demzufolge auch der Schichtaufbau nicht kontrolliert stattfindet.

Aus US 4,726,715 und EP 3 396 731 A1 ist bekannt, beim Dosieren pulverförmiger Stoffe für die Vorratsbehälter einen Druckausgleich durch Belüftungsleitungen vorzusehen.

Ausgehend von diesem diskutierten Stand der Technik liegt der Erfindung daher die Aufgabe zugrunde, eine Dosiervorrichtung der eingangs genannten Art dergestalt weiterzubilden, dass mit dieser auch eine Dosierung von pulverförmigen Stoffen, deren Partikel nur eine geringe Korngröße aufweisen, auch in Geringstmengen möglich ist, ohne die zum Stand der Technik aufgezeigten Nachteile hinnehmen zu müssen. Zugleich liegt der Erfindung die Aufgabe zu Grunde, die Betriebsweise einer herkömmlichen Dosiervorrichtung zu verbessern.

Gelöst wird diese Aufgabe erfindungsgemäß durch eine in Anspruch 1 definierte Dosiervorrichtung, bei der an die Trägergasleitung in Strömungsrichtung des Trägergases vor Passieren des Zutritts der durch die Mündung des Förderkanals geförderten pulverförmigen Stoffpartikel eine Belüftungsleitung mit ihrem ersten Ende angeschlossen ist, die mit ihrem anderen Ende, mit dem Inneren des Vorratsbehälters in Fluidverbindung stehend, an diesen angeschlossen ist und bei der in den Abschnitt der Trägergasleitung zwischen der Mündung der Belüftungsleitung und dem Zutritt der durch die Mündung des Förderkanals geförderten pulverförmigen Stoffpartikel ein Schaltventil eingeschaltet ist.

Die verfahrensbezogene Aufgabe wird erfindungsgemäß durch ein Verfahren zum Betreiben einer Dosiervorrichtung gemäß Anspruch 1 gelöst, bei dem in dem Vorratsbehälter in Folge seines Anschlusses an den CVD-Reaktor der CVD-Anlage bei einem Betrieb der Dosiervorrichtung derselbe oder ein nur geringfügig höherer Druck herrscht als in dem CVD-Reaktor und bei dem zum Auflockern von in dem Vorratsbehälter befindlichen Stoff intermittierend der Innendruck in dem Vorratsbehälter erhöht und anschließend spontan oder quasi spontan wieder abgesenkt ist.

Bei dieser Dosiervorrichtung - entsprechendes gilt für das beanspruchte Verfahren - ist vorgesehen, dass das Innere des Vorratsbehälters ebenfalls trägergasbeaufschlagt ist. Diesem Zweck dient eine Belüftungsleitung, die als Abzweig von der Trägergasleitung in das Innere des Vorratsbehälters mündet. Die Belüftungsleitung mündet vorzugsweise in das Innere des Vorratsbehälters im Bereich seines dem Auslauf gegenüberliegenden Endes. Als Vorratsbehälter eignet sich ein stehender Körper. Dieser ist typischerweise zylinderförmig konzipiert, weist zumindest eine zylindrische innere Mantelfläche auf. Diese Dosiervorrichtung verfügt über eine in die Trägergasleitung in Strömungsrichtung des Trägergases vor der Mündung der pulverförmigen Stoffzuführung eingeschaltetes Schaltventil. Mittels des Schaltventiles kann der an der Mündung des Förderkanals vorbeiströmende Trägergasstrom als Zustrom in einen Reaktor, typischerweise einem CVD-Reaktor durchgelassen oder gesperrt werden. Zum Zuführen des pulverförmigen Stoffes als Precursor einer Verdampfungseinrichtung, beispielsweise innerhalb eines CVD-Reaktors angeordnet, befindet sich das Schaltventil in seiner Durchlassstellung. Ausgenutzt wird bei dieser Dosiervorrichtung, wenn als Teil einer CVD-Anlage eingesetzt, dass die Trägergasleitung in den CVD-Reaktor mündet und dass bei einem Betrieb der CVD-Anlage in dem CVD-Reaktor ein Unterdruck (Vakuum), typischerweise zwischen 1 mbar und 50 mbar herrscht. Mit dieser Dosiervorrichtung als Teil einer CVD-Anlage oder einer anderen Anlage, bei der der Trägergasstrom an ein Behältnis angeschlossen ist, in dem ein Unterdruck herrscht, kann über die Belüftungsleitung der in dem Vorratsbehälter befindliche pulverförmige Stoff aufgelockert werden.

Bei einer Zuführung des pulverförmigen Stoffes etwa als Precursor zum Zuführen desselben in einen CVD-Reaktor ist das Schaltventil geöffnet, damit der Trägergasstrom an der Mündung des Förderkanals vorbeistreicht und die aus der Mündung durch die Förderschnecke heraustransportierten Stoffpartikel als Schwebfracht mitnimmt. Aufgrund des Anschlusses der Trägergasleitung an einen Unterdruck-Reaktor stellt sich auch über die Förderschnecke in dem Vorratsbehälter ein entsprechender Unterdruck ein. Zum Auflockern des in dem Vorratsbehälter befindlichen pulverförmigen Stoffes wird das Schaltventil kurzzeitig geschlossen. Ist das Schaltventil geschlossen, erhöht sich aufgrund der Trägergaszufuhr in den Vorratsbehälter der in diesem herrschende Druck, was zunächst zu einer gewissen Kompaktion des pulverförmigen Stoffes führen kann. Wird anschließend das Schaltventil wieder geöffnet, wird über die Belüftungsleitung und den sich daran anschließenden Abschnitt der Trägergasleitung der zuvor im Vorratsbehälter herrschende Druck eingebracht, was zu einer Verwirbelung des darin befindlichen pulverförmigen Stoffes führt. Diese durch die plötzliche Druckerniedrigung bewirkte Verwirbelung lockert den Partikelverbund des pulverförmigen, in dem Vorratsbehälter bevorrateten Stoffes auf. Die Frequenz, mit der eine solche Auflockerung des pulverförmigen Stoffes herbeigeführt wird, wird man in Abhängigkeit von der Kompaktionstendenz des pulverförmigen Stoffes vornehmen. Dieses wird intermittierend, etwa einmal pro Minute oder auch einmal pro mehrere Minuten vorgenommen werden. Auch andere Frequenzen können für die intermittierende Druckerhöhung in dem Vorratsbehälter vorgesehen sein, und zwar in Abhängigkeit von dem in dem Vorratsbehälter befindlichen Stoff. Es wird als ausreichend angesehen, wenn das Schaltventil nur für kurze Zeit, d.h. für 0,5 bis 3 sec. geschlossen bleibt. Auf diese Weise ist die Precursorzufuhr in beispielsweise einen CVD-Reaktor nur kurzzeitig und für den Abscheideprozess nicht oder jedenfalls nicht signifikant spürbar unterbrochen. Dieses Konzept der Entkompaktierung von in dem Vorratsbehälter befindlichen pulverförmigen Stoff, insbesondere von kleiner Partikelgröße ist besonders effektiv für die gewünschte Auflockerung des pulverförmigen Stoffes im Vorratsbehälter. Es war überraschend zu beobachten, dass sich der beschriebene Auflockerungserfolg einstellt, obwohl infolge der zunächst erfolgenden Druckerhöhung im Vorratsbehälter der darin befindliche pulverförmige Stoff etwas kompaktiert wird, mithin zunächst genau das Gegenteil bewirkt wird, was eigentlich erreicht werden soll. Die vorbeschriebene quasi spontane Druckerniedrigung stellt sich ein, da ein Druckausgleich durch den in dem Vorratsbehälter bevorrateten pulverförmigen Stoff und den Förderkanal mit der darin befindlichen Förderschnecke aufgrund der auf dieser Strecke nur geringen Gaswegsamkeiten für die gewünschten Zwecke nur deutlich langsamer stattfindet und daher vernachlässigbar ist.

Um einen unkontrollierten Eintrag von in dem Vorratsbehälter befindlichen pulverförmigen Stoff in den Reaktor über die Belüftungsleitung beim Öffnen des Schaltventils zu unterbinden, ist in einem Ausführungsbeispiel vorgesehen, den in dem Vorratsbehälter befindlichen Vorrat an pulverförmigem Stoff von der Belüftungsleitung durch einen Filter zu trennen. Dieser ist gasdurchlässig, jedoch nicht durchlässig für den pulverförmigen Stoff. Aufgrund des vorbeschriebenen Wirkzusammenhangs einer anfänglichen Druckerhöhung in dem Vorratsbehälter, gefolgt von einer anschließenden raschen, quasi spontanen Druckerniedrigung ist zugleich Sorge dafür getragen, dass sich der Filter über die Zeit nicht zusetzt. Um dieses zu erreichen wird das diesem Prozess steuernde Schaltventil entsprechend rasch geöffnet. Aus diesem Grunde ist es zweckmäßig, als Schaltventil ein Magnetventil einzusetzen. Schließlich strömt bei jedem Vorgang der Druckerhöhung im Vorratsbehälter zunächst Trägergas in den Vorratsbehälter ein, drückt somit in dessen Poren befindliche Stoffpartikel aus diesen heraus, sodass die sich beim Öffnen des Schaltventils gewünschte quasi spontane Druckerniedrigung aufgrund des freien, sauberen Filters einstellt.

Eine solche Dosiervorrichtung kann über wenigstens ein Reinigungsritzel verfügen, welches im Bereich des Auslaufes des Vorratsbehälters mit seinen Zähnen die Wendel der Förderschnecke kämmt. Dieses Ritzel ist drehbar gelagert. Das Ritzel befindet sich typischerweise benachbart zu oder dem Auslauf gegenüberliegend. Bei einer Drehbewegung der Förderschnecke kämmt das Reinigungsritzel mit seinen Zähnen die Wendel der Förderschnecke, sodass hierdurch die Wendelzwischenräume frei gehalten werden. Unter Umständen sich in der Wendel der Förderschnecke angesammelter, kompaktierter pulverförmiger Stoff, der aufgrund seiner Kompaktion nicht von selbst herausfällt, wird durch das Reinigungsritzel herausgebracht. Die Anordnung des Reinigungsritzels im Bereich des Auslaufes des Vorratsbehälters sorgt dafür, dass eine Verbackung bzw. Kompaktierung des pulverförmigen Stoffes zu Beginn der Förderstrecke innerhalb des Förderkanals nicht eintritt. Vorzugsweise entspricht der Durchmesser des Auslaufes des Vorratsbehälters bzw. der Eingangsöffnung des Förderkanals zum Zuführen von pulverförmigem Stoff an die Förderschnecke dem Durchmesser des Reinigungsritzels, ist jedenfalls nicht signifikant größer als der Durchmesser des Reinigungsritzels. Dieses gewährleistet, dass das Reinigungsritzel über die gesamte Breite des Auslaufes bzw. des Zustromes des pulverförmigen Stoffes auf die Förderschnecke deren Förderwendel reinigt. Durch das Reinigungsritzel wird Sorge dafür getragen, dass zumindest weitestgehend nur teilgefüllte Förderwendelzwischenräume bei einer Rotationsbewegung der Förderschnecke in dem Bereich des Auslaufes des Vorratsbehälters bzw. die Eingangsmündung des Förderkanals eingebracht werden.

Der Auslauf des Vorratsbehälters ist typischerweise in Richtung zur Förderschnecke hin verjüngt, typischerweise konisch verjüngt ausgeführt.

Zum Unterstützen einer Auflockerung des pulverförmigen Stoffes in dem Vorratsbehälter ist in einer Ausführung einer solchen Dosiervorrichtung vorgesehen, dass innerhalb des Vorratsbehälters ein oder mehrere Mischwerkzeuge angeordnet sind. Bei einem stehenden Vorratsbehälter erstreckt sich die Drehachse des oder der Mischwerkzeuge in Längserstreckung des Vorratsbehälters. Bei einem solchen Mischwerkzeug kann es sich beispielsweise um einen Mischwendel handeln. Typischerweise greift diese bis in den Auslauf ein. Ist der Auslauf trichterförmig in Richtung zu dem Förderkanal hin verjüngt, ist dementsprechend auch der Durchmesser der Förderwendel verjüngt. Das oder die Mischwerkzeuge sind rotatorisch durch einen Antrieb angetrieben, typischerweise einen Elektromotor, durchaus ausgeführt als Schrittmotor.

Der Vorratsbehälter ist oberseitig mit einem Verschlusskörper abgedichtet verschlossen. Dieser Verschlusskörper ist abnehmbar, um den Vorratsbehälter befüllen zu können. Im Falle des Vorsehens eines oder mehrerer Mischwerkzeuge durchgreift bei Vorsehen eines solchen Verschlusskörpers die Mischwerkzeugwelle den Verschlusskörper, beispielsweise mit einem Antriebsabschnitt. Dieser Durchgriff durch den Verschlusskörper ist abgedichtet. Außerhalb der Abdichtung des Verschlusskörpers befindet sich der Antrieb zum rotatorischen Antreiben des oder der Mischwerkzeuge.

Zur Unterstützung der Förderung des feinkörnigen pulverförmigen Stoffes mittels der Förderschnecke durch den Förderkanal ist in einer Weiterbildung vorgesehen, dass die Innenwand des Förderkanals Strukturen aufweist und/oder entsprechend ausgebildet ist, damit sich daran pulverförmiger Stoff festsetzen kann. Dieser bildet eine wandreibungserhöhende Beschichtung, wodurch der Förderprozess des pulverförmigen Stoffes durch den Förderkanal begünstigt ist. Als Innenwandstrukturen eignen sich für diesen Zweck beispielsweise Gewindestrukturen. Eine solche wandreibungserhöhende Beschichtung lässt sich auch einstellen, wenn der Förderkanal in Richtung zu der Mündung des Förderkanals hin eine sich kontinuierlich geringfügig vergrößernde Querschnittsfläche aufweist. Diese mit geringem Winkel konische Vergrößerung des Förderkanals bewirkt ebenfalls ein Anbacken einer Stoffschicht an der Innenwand des Förderkanals.

Mit einer Dosiervorrichtung, wie vorbeschrieben, lassen sich Förderraten von 2 g/h und weniger, durchaus auch weniger als 0,1 g/h erreichen. Bemerkenswert ist hieran, dass die Dosierung der Geringstmenge eine Feststoffdosierung ist.

Mit einer solchen Dosiervorrichtung werden somit keine nennenswerten, für die Schichtbildung nicht gewünschten Stoffe in den CVD-Reaktor eingebracht. Dieser benötigt daher keine aufwändige Kühlfallentechnologie zum Zurückgewinnen des bei einer Flüssigdosierung notwendigerweise eingesetzten Lösemittels. Entsprechend fehlerloser lassen sich auch die auf dem Substrat abzuscheidenden Schichten, beispielsweise metallische Schichten, oxydische Schichten, karbidische Schichten oder boridische Schichten abscheiden.

Eine solche Dosiervorrichtung benötigt nicht sehr viel Bauraum. Mit diesem Konzept einer Feststoffdosierung besteht ohne weiteres die Möglichkeit, dass an einen CVD-Reaktor mehrere derartige Dosiervorrichtungen angeschlossen sind. Diese können typischerweise unabhängig voneinander angesteuert werden. Bei einer solchen Ausgestaltung ist es zweckmäßig, dass der pulverförmige Stoff jedes dieser Dosiervorrichtungen an ein und demselben Verdampfer verdampft wird. Dieser befindet sich zweckmäßigerweise innerhalb des CVD-Reaktors, kann jedoch auch dem Eingang der Trägergasleitung in den CVD-Reaktor vorgeschaltet sein. Wenn die einzelnen Dosiervorrichtungen zumindest teilweise unterschiedliche Stoffe enthalten, können auf dem Substrat Mischschichten abgeschieden werden. Gleichfalls besteht die Möglichkeit, auf dem Substrat mehrere aufeinander folgende, unterschiedliche Schichten abzuscheiden. Durchaus möglich ist es bei diesem Konzept auch, dass Schichten mit unterschiedlichen Eigenschaften aufeinander abgeschieden werden, beispielsweise eine Wechselfolge von metallischen und oxydischen Schichten. Wenn an einen CVD-Reaktor mehrere Dosiervorrichtungen angeschlossen sind, kann auch vorgesehen sein, dass zwei Dosiervorrichtungen für die Dosierung ein und desselben Stoffes vorgesehen sind. Dann braucht der Abscheidungsprozess zum Nachfüllen des Vorratsbehälters eines dieser Dosiervorrichtungen nicht unterbrochen zu werden, da dann vor der Entleerung des Vorratsbehälters einer ersten Dosiervorrichtung diese abgeschaltet und diejenige zugeschaltet wird, in dessen Vorratsbehälter derselbe Stoff enthalten ist. Der Vorratsbehälter der abgeschalteten Dosiervorrichtung kann dann geöffnet und mit neuem pulverförmigem Stoff gefüllt werden.

Nachfolgend ist die Erfindung anhand eines Ausführungsbeispiels unter Bezugnahme auf die beigefügten Figuren beschrieben. Es zeigen:
- **Fig. 1**:: Ein schematisiertes Blockschaltbild einer CVD-Anlage mit einer erfindungsgemäßen Dosiervorrichtung und
- **Fig. 2:**: eine vergrößerte Darstellung eines Ausschnitts der Dosiervorrichtung der Figur 1.

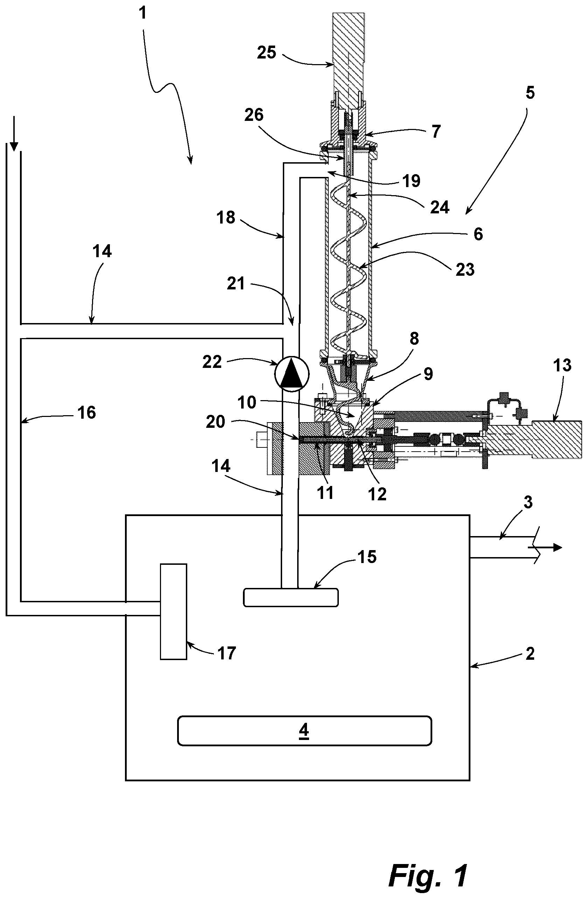

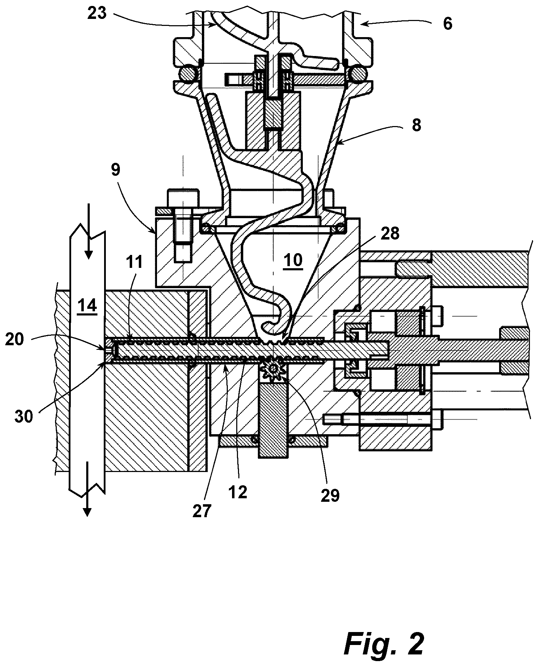

Eine CVD-Anlage 1 umfasst einen CVD-Reaktor 2, dessen Inneres an eine Vakuumpumpe angeschlossen ist. Mittels der Vakuumpumpe kann der Druck in dem CVD-Reaktor 2 hinreichend abgesenkt werden, um einen chemischen Dampfabscheideprozess ausführen zu können. Angeschlossen ist die in der Figur nicht dargestellte Vakuumpumpe an eine in das Innere des CVD-Reaktors 2 mündende Pumpenleitung 3. Der CVD-Reaktor 2 ist öffenbar, um auf einem Träger 4 ein durch den CVD-Prozess zu beschichtendes Substrat auflegen und von diesem wieder entfernen zu können. Zum Zuführen eines Precursors zum Abscheiden einer beispielsweise metallischen Schicht auf einem auf dem Träger 4 aufgelegten Substrat dient eine mit dem Bezugszeichen 5 gekennzeichnete Dosiervorrichtung. Die Dosiervorrichtung 5 verfügt über einen Vorratsbehälter 6, der bei dem dargestellten Ausführungsbeispiel zylindrisch ausgeführt ist. Der Vorratsbehälter 6 ist oberseitig durch einen Verschlusskörper 7 abgedichtet verschlossen. Der stehende Vorratsbehälter 6 verfügt unterseitig über einen konisch verjüngten Auslauf 8. Der Vorratsbehälter 6 ist auf einem Förderblock 9 montiert, der an seiner zu dem Vorratsbehälter 6 weisenden Seite über eine trichterförmige Mündung verfügt, die die Verjüngung des Auslaufes 8 fortsetzt. Die Ausgestaltung des Förderblockes 9 mit seinen Einzelteilen ist nachstehend noch näher unter Bezugnahme auf die Darstellung der Figur 2 beschrieben. Das verjüngte Ende der konischen auslaufverlängernden Verjüngung 10 des Förderblockes 9 mündet in einen quer zur Auslaufrichtung aus dem Vorratsbehälter 6 verlaufenden Förderkanal 11 mit einer darin integrierten Förderschnecke 12. Die Förderschnecke 12 ist durch einen Schrittmotor 13 rotatorisch angetrieben. Der Förderkanal 11 mündet in eine Trägergasleitung 14. Die Förderschnecke 12 dient zum Zuführen von in dem Vorratsbehälter 6 bevorratetem pulverförmigen Stoff als Precursor für die abzuscheidende Schicht in einen bei einem Betrieb der CVD-Anlage 1 die Trägergasleitung 14 durchströmenden Trägergasstrom. Die Strömungsrichtung des Trägergasstromes ist in Richtung zu dem CVD-Reaktor 2. Die Trägergasleitung 14 mündet in den CVD-Reaktor und setzt sich in diesem bis zu einem Verdampfer 15 fort. Der mit dem Trägergasstrom zugeführte Precursor verdampft an dem Verdampfer 15. Das durch den Verdampfungsprozess freigesetzte Metall bei einer metallischen Beschichtung scheidet sich dann auf der Oberfläche des auf dem Träger 4 befindlichen Substrates ab. Im Betrieb befindet sich in dem CVD-Reaktor 2 typischerweise ein Druck von nur 2 bis 5 mbar. Die Trägergasleitung 14 ist an einen in der Figur nicht dargestellten Trägergasvorrat oder eine Trägergasversorgung angeschlossen, von dem Trägergas gemäß der in Figur 1 gekennzeichneten Pfeilrichtung in die Trägergasleitung 14 einströmt. Ein Ast 16 der Trägergasleitung 14 führt auf direktem Wege in den CVD-Reaktor 2 in einen Gasduschkopf 17.

Von Besonderheit bei der Dosiervorrichtung 5 ist, dass das Innere des Vorratsbehälters 6 ebenfalls in Fluidkommunikation mit der Trägergasleitung 14 steht. Zu diesem Zweck ist eine Belüftungsleitung 18 vorgesehen, durch die das Innere des Vorratsbehälters 6 mit der Trägergasleitung 14 verbunden ist. In der Figur in nicht näher dargestellter Art und Weise befindet sich im Bereich der Mündung 19 der Belüftungsleitung 18 ein Filter, der für das Trägergas durchlässig, nicht jedoch durchlässig für den in dem Vorratsbehälter 6 bevorrateten pulverförmigen Stoff ist. Zwischen der Mündung 20 des Förderkanals 11 in die Trägergasleitung 14 und der Mündung 21 der Belüftungsleitung 18 in die Trägergasleitung 14 ist in die Trägergasleitung 14 ein Schaltventil 22 eingeschaltet. Bei dem Schaltventil 22 handelt es sich bei dem dargestellten Ausführungsbeispiel um ein Magnetventil. Dieses ist in nicht näher dargestellter Art und Weise an eine Steuereinheit angeschlossen.

In dem Vorratsbehälter 6 ist ein wendelartig ausgeführtes Mischwerkzeug 23 angeordnet. Dieses ist bei dem dargestellten Ausführungsbeispiel zweiteilig aufgebaut. Ein erstes Werkzeugteil befindet sich in dem zylindrischen Teil des Vorratsbehälters 6. Ein zweiter Wendelabschnitt befindet sich in dem Bereich des Auslaufes 8 und erstreckt sich bis in die konische Verjüngung 10 als Teil des Auslaufes des Förderblockes 9. Die Antriebswelle 24 des Mischwerkzeuges 23 durchgreift den Verschlusskörper 7 in abgedichteter Weise und ist an einen elektromotorischen Antrieb 25 angeschlossen. Der elektromotorische Antrieb 25, bei dem es sich ebenfalls um einen Schrittmotor bei dem dargestellten Ausführungsbeispiel handelt, ist an dem Verschlusskörper 7 befestigt. Da der Verschlusskörper 7 zum Öffnen und Nachfüllen des Vorratsbehälters 6 von diesem demontiert und auch wieder an diesem montiert werden muss, ist Teil der Antriebswelle 24 ein Kupplungsstück 26, welches auf den oberen Abschnitt der Antriebswelle 24 des Mischwerkzeuges 23 drehmomentschlüssig aufgesteckt ist. Das Kupplungsstück 26 kann zusammen mit der dem Verschlusskörper 7 von der Antriebswelle abgezogen werden. Das Kupplungsstück 26 durchgreift den Verschlusskörper 7 abgedichtet.

Figur 2 zeigt den Förderblock 9 in einer vergrößerten und damit detaillierteren Darstellung. In den Förderblock 9 ist zur Ausbildung des Förderkanals 11 ein Förderkanalrohr 27 eingesetzt. In diesem befindet sich die Förderschnecke 12, wobei der Außendurchmesser der Förderschnecke 12 geringfügig kleiner ist als der Innendurchmesser des Förderkanalrohres 27 und damit des Förderkanals 11. An der Innenwand des Förderkanalrohres 27 sind gewindeartige Innenwandstrukturen eingebracht, die als Falle für den durch den Förderkanal 11 geförderten pulverförmigen Stoff dienen. Dieses dient zur Ausbildung einer Beschichtung aus dem pulverförmigen Stoff an der Innenwand des Förderkanalrohres 27. Das Förderkanalrohr 27 weist an seiner zu der Auslaufverjüngung 10 des Förderblockes 9 weisenden Seite eine Öffnung 28 auf, durch die der in dem Vorratsbehälter 6 befindliche pulverförmige Stoff in den Förderkanal 12 eindringen kann. Dieser Öffnung 28 gegenüberliegend ist in dem Förderblock 9 ein Reinigungsritzel 29 drehbar gelagert. Dieses kämmt mit seinen Zähnen die Förderwendel der Förderschnecke 12. Bei einem Drehantrieb der Förderschnecke 12 dreht das Reinigungsritzel 29 mit. Aufgrund des bzw. der in die Förderwendelzwischenräume eingreifenden Zähne des Reinigungsritzels 29 wird aus diesen darin befindlicher kompaktierter pulverförmiger Stoff entfernt. In nicht dargestellter Art und Weise ist an den Innenraum, in dem das Reinigungsritzel 29 angeordnet ist, eine Materialfalle angeschlossen, um den aus den Förderwendelzwischenräumen herausgedrückten Stoff auffangen zu können.

Das Förderkanalrohr 27 ist an seiner in die Trägergasleitung 14 angeordneten Mündung durch eine Düse 30 verschlossen. Der Durchmesser der Düse 30 ist um ein Mehrfaches kleiner als der Durchmesser des Förderkanals 11. Hierdurch stellt sich ein gewisser Venturi-Effekt als Folge des an der Mündung 20 vorbeistreichenden Trägergasstroms ein, durch den durch die Förderschnecke 12 geförderte Feststoffpartikel mitgerissen und als Schwebfracht dem Verdampfer 15 zugeführt werden.

Bei einem Betrieb der Fördereinrichtung 5 wird das Mischwerkzeug 23 durch den Schrittmotor 25 rotatorisch angetrieben, um ein unerwünschtes Kompaktieren des nur eine sehr geringe Korngröße aufweisenden, darin bevorrateten Stoffes möglichst zu unterbinden. Zugleich dient das Förderwerkzeug 23 dem Zweck, einen Nachschub von pulverförmigem Stoff in den Auslauf 8 und die Verjüngung 10 des Förderblockes 9 sicherzustellen. Bei einem Betrieb der CVD-Anlage 1 herrscht in dem Inneren des Vorratsbehälters 6 und dem Förderkanal 12 aufgrund des Unterdruckes in dem CVD-Reaktor 2 ebenfalls ein Unterdruck. Dieser ist typischerweise um wenige mbar höher als der Druck innerhalb des CVD-Reaktors 2.

Der in dem Vorratsbehälter 6 befindliche pulverförmige Stoff, der beispielsweise eine Korngröße von 30 bis 50 µm aufweist, wird bei einem Betrieb der CVD-Anlage 1 einmal pro Minute aufgelockert. Zu diesem Zweck wird das Schaltventil 22 geschlossen, sodass an der Mündung 20 des Förderkanals 11 kein Trägergas vorbeiströmt. Die Trägergaszufuhr bleibt jedoch konstant. Infolge dessen erhöht sich über die Belüftungsleitung 18 der Druck im Inneren des Vorratsbehälters 6. Dieses führt zwar zunächst zu einer gewissen Kompaktion des darin bevorrateten pulverförmigen Stoffes. Diese Druckerhöhung wird jedoch genutzt, um anschließend eine in kurzer Zeit und somit quasi spontan stattfindende Druckerniedrigung dadurch herbeizuführen, dass das Schaltventil 22 nach beispielsweise 1 bis 2 Sekunden, also: Nach einer erfolgten Druckerhöhung, wieder geöffnet wird. Aufgrund der dann vorhandenen direkten Wegsamkeit zwischen dem Inneren des Vorratsbehälters 6 und dem in dem CVD-Reaktor 2 herrschenden Unterdruck führt dies zu einer wirksamen Aufwirbelung des in dem Vorratsbehälter 6 befindlichen pulverförmigen Stoffes. Auf diese Weise ist wirksam einer Kompaktion des als Precursor dem CVD-Reaktor 2 zuführenden Feststoffes entgegengewirkt und somit eine bezüglich der Dosierungsrate kontinuierliche Zuführung desselben gewährleistet. Durch diese Maßnahme wird auch eine unter Umständen durch das Mischwerkzeug verursachte Kompaktion von pulverförmigem Stoff wieder aufgelockert.

Wenn im Rahmen dieser Ausführungen von einem pulverförmigen Stoff die Rede ist, versteht es sich, dass hierunter auch Stoffgemische zu subsumieren sind.

Die Erfindung ist anhand eines Ausführungsbeispiels beschrieben. Ohne den Umfang der geltenden Ansprüche zu verlassen, ergeben sich für einen Fachmann auch andere Möglichkeiten die Erfindung umzusetzen, ohne dass dieses im Rahmen dieser Ausführungen näher erläutert werden müsste.

### Bezugszeichenliste

- 1: CVD-Anlage
- 2: CVD-Reaktor
- 3: Pumpenleitung
- 4: Träger
- 5: Dosiervorrichtung
- 6: Vorratsbehälter
- 7: Verschlusskörper
- 8: Auslauf
- 9: Förderblock
- 10: Verjüngung
- 11: Förderkanal
- 12: Förderschnecke
- 13: Schrittmotor
- 14: Trägergasleitung
- 15: Verdampfer
- 16: Ast der Trägergasleitung
- 17: Gasduschkopf
- 18: Belüftungsleitung
- 19: Mündung
- 20: Mündung
- 21: Mündung
- 22: Schaltventil
- 23: Mischwerkzeug
- 24: Antriebswelle
- 25: Elektromotorischer Antrieb
- 26: Kupplungsstück
- 27: Förderkanalrohr
- 28: Öffnung
- 29: Reinigungsritzel
- 30: Düse

## Patentansprüche

1. Dosiervorrichtung zum Dosieren eines pulverförmigen Stoffes, insbesondere eines Precursors zum Zuführen desselben in einen CVD-Reaktor (2) einer CVD-Anlage (1) zum Abscheiden etwa einer metallischen Schicht auf einem Substrat, umfassend einen Vorratsbehälter (6) zum Bevorraten des pulverförmigen Stoffes mit einem Auslauf (8), eine unterhalb des Auslaufes (8) in einem Förderkanal (11) angeordnete Förderschnecke (12) mit einer Förderrichtung quer zur Auslaufrichtung des Vorratsbehälters (6) zum Fördern des pulverförmigen Stoffes von dem Auslauf (8) zu einer Mündung (20), an der der geförderte pulverförmige Stoff als Schwebfracht von einem an der Mündung (20) vorbeiströmenden Trägergasstrom aufgenommen wird, und eine Trägergasversorgung mit einer an eine Trägergasquelle anschließbaren, an der Mündung (20) des Förderkanals (11) oder einer Verlängerung derselben vorbeigeführten und an einen CVD-Reaktor (2) anschließbaren Trägergasleitung (14), **dadurch gekennzeichnet, dass** an die Trägergasleitung (14) in Strömungsrichtung des Trägergases vor Passieren des Zutritts der durch die Mündung (20) des Förderkanals (11) geförderten pulverförmigen Stoffpartikel eine Belüftungsleitung (18) mit ihrem ersten Ende angeschlossen ist, die mit ihrem anderen Ende, mit dem Inneren des Vorratsbehälters (6) in Fluidverbindung stehend, an diesen angeschlossen ist und dass in den Abschnitt der Trägergasleitung (14) zwischen der Mündung (21) der Belüftungsleitung (18) und dem Zutritt der durch die Mündung (20) des Förderkanals (11) geförderten pulverförmigen Stoffpartikel ein Schaltventil (22) eingeschaltet ist.

2. Dosiervorrichtung nach Anspruch 1, **dadurch gekennzeichnet, dass** die Belüftungsleitung (18) im Bereich des dem Auslauf (8) gegenüberliegenden Endes des Vorratsbehälters (6) in diesen mündet.

3. Dosiervorrichtung nach Anspruch 1 oder 2, **dadurch gekennzeichnet, dass** die Belüftungsleitung (18) von dem in dem Vorratsbehälter (6) befindlichen pulverförmigen Stoff durch einen Filter getrennt ist.

4. Dosiervorrichtung nach einem der Ansprüche 1 bis 3, **dadurch gekennzeichnet, dass** das Schaltventil (22) ein Auf-Zu-Ventil ist.

5. Dosiervorrichtung nach einem der Ansprüche 1 bis 4, **dadurch gekennzeichnet, dass** die Mündung (20) des Förderkanals (11) als Verengung ausgeführt ist.

6. Dosiervorrichtung nach einem der Ansprüche 1 bis 5, **dadurch gekennzeichnet, dass** der Vorratsbehälter (6) ein stehender zylindrischer Behälter ist, bei dem sich der Auslauf (8) zuunterst befindet und dessen obere Öffnung mit einem Verschlusskörper (7) abgedichtet verschlossen ist.

7. Dosiervorrichtung nach einem der Ansprüche 1 bis 6, **dadurch gekennzeichnet, dass** in dem Vorratsbehälter (6) zumindest ein rotatorisch angetriebenes Mischwerkzeug (23) zum Auflockern des darin bevorrateten pulverförmigen Stoffes angeordnet ist, dessen Antriebswelle (24) der Längserstreckung des Vorratsbehälters (6) folgt und sich mit einem Antriebsabschnitt oder einem Kupplungsabschnitt (26) abgedichtet durch den Verschlusskörper (7) erstreckt und an einem außenseitig bezüglich der Abdichtung angeordneten Drehantrieb angeschlossen ist.

8. Dosiervorrichtung nach einem der Ansprüche 1 bis 7, **dadurch gekennzeichnet, dass** im Bereich des Auslaufes (8) benachbart zu diesem oder gegenüberliegend zumindest ein drehbar gelagertes Reinigungsritzel (29) die Förderschnecke (12) kämmt.

9. Dosiervorrichtung nach Anspruch 8, **dadurch gekennzeichnet, dass** der Förderkanal (11) ein oder mehrere Innenwandstrukturen zum Ausbilden einer wandreibungserhöhenden Beschichtung aus dem pulverförmigen Stoff aufweist.

10. Dosiervorrichtung nach Anspruch 9, **dadurch gekennzeichnet, dass** als Innenwandstruktur eine gewindeförmig ausgeführte Innenwandstruktur vorgesehen ist.

11. Dosiervorrichtung nach Anspruch 10, **dadurch gekennzeichnet, dass** der Förderkanal zum Ausbilden einer wandreibungserhöhenden Beschichtung aus dem pulverförmigen Stoff vom Auslauf in Richtung zur Förderkanalmündung hin in zumindest einem Abschnitt mit einer sich kontinuierlich vergrößernden Querschnittsfläche ausgeführt ist, wodurch sich der radiale Abstand zur Förderschnecke vergrößert.

12. Dosiervorrichtung nach einem der Ansprüche 1 bis 11, **dadurch gekennzeichnet, dass** diese Teil einer CVD-Anlage mit einem an eine Trägergasversorgung und eine Vakuumpumpe angeschlossenen CVD-Reaktor (2) ist und dass das in die Trägergasleitung (14) eingeschaltete Schaltventil (22) zu seiner Ansteuerung an eine Steuerung der CVD-Anlage (1) angeschlossen ist.

13. Dosiervorrichtung nach Anspruch 12, **dadurch gekennzeichnet, dass** die CVD-Anlage neben der Dosiervorrichtung mehrere weitere, an den CVD-Reaktor angeschlossene Dosiervorrichtungen mit unterschiedlichen pulverförmigen Stoffen aufweist.

14. Verfahren zum Betreiben einer Dosiervorrichtung gemäß Anspruch 1, **dadurch gekennzeichnet, dass** in dem Vorratsbehälter (6) in Folge seines Anschlusses an den CVD-Reaktor (2) der CVD-Anlage (1) bei einem Betrieb der Dosiervorrichtung (5) derselbe oder ein nur geringfügig höherer Druck herrscht als in dem CVD-Reaktor (2) und dass zum Auflockern von in dem Vorratsbehälter (6) befindlichen Stoff intermittierend der Innendruck in dem Vorratsbehälter (6) erhöht und anschließend spontan oder quasi spontan wieder abgesenkt ist.

15. Verfahren nach Anspruch 14, **dadurch gekennzeichnet, dass** die Innendruckerhöhung in dem Vorratsbehälter (6) durch Einleiten von der CVD-Anlage (1) zugeführtem Trägergas vorgenommen wird, während zeitgleich die Trägergaszufuhr in den CVD-Reaktor (2) unterbrochen wird, und dass die anschließende Druckerniedrigung durch Öffnen der Trägergaszufuhr in den Reaktor (2) herbeigeführt wird.

## Claims

1. Dosing device for dosing a powdery substance, in particular a precursor, for delivery into a CVD reactor (2) of a CVD system (1), for example for precipitation of a metallic layer onto a substrate, comprising a storage container (6) for storing the powdery substance with an outlet (8), a screw conveyor (12) arranged in a conveying channel (11) beneath the outlet (8), transverse to the outlet direction of the storage container (6), for conveying the powdery substance from the outlet (8) to a mouth (20), at which the powdery substance being conveyed is taken up in the form of a suspension by a carrier gas flow flowing past at the mouth (20), and a carrier gas supply, with a carrier gas line (14) which can be connected to the mouth (20) of the conveying channel (11) or an extension of that channel and which can also be connected to a CVD reactor (2), **characterised in that** a ventilation line (18) is connected by its first end to the carrier gas line (14) in the flow direction of the carrier gas, before passing the introduction of the powdery substance particles being conveyed through the mouth (20) of the conveying channel (11), and which is connected by its other end to the storage container (6), with the interior of which it is in fluid connection, and that a switching valve (22) is integrated into the section of the carrier gas line (14) between the mouth (21) of the ventilation line (18) and the introduction of the powdery substance particles being conveyed through the mouth (20) of the delivery channel (11).

2. Dosing device according to claim 1, **characterised in that** the ventilation line (18) opens into the storage container (6) in the region of the end located opposite the outlet (8).

3. Dosing device according to claim 1 or 2, **characterised in that** the ventilation line (18) is separated by a filter from the powdery substance located in the storage container (6).

4. Dosing device according to any one of claims 1 to 3, **characterised in that** the switching valve (22) is an open-close valve.

5. Dosing device according to any one of claims 1 to 4, **characterised in that** the mouth (20) of the conveying channel (11) is configured such as to taper.

6. Dosing device according to any one of claims 1 to 5, **characterised in that** the storage container (6) is an upright cylindrical container, of which the outlet (8) is located at the lowest point and of which the upper opening is closed and sealed by a closure body (7).

7. Dosing device according to any one of claims 1 to 6, **characterised in that** at least one rotationally driven mixing tool (23) is arranged in the storage container (6) in order to loosen the powdery substance stored in it, the drive shaft (24) of which follows the longitudinal extension of the storage container (6) and extends with a drive section or a coupling section (26) sealed by the closure body (7), and is connected to a rotary drive which is arranged on the outside in relation to the seal.

8. Dosing device according to any one of claims 1 to 7, **characterised in that** in the region of the outlet (8), adjacent to it or located opposite, at least one rotatably mounted cleaning pinion (29) engages with the screw conveyor (12).

9. Dosing device according to claim (8), **characterised in that** the conveying channel (11) comprises one or more inner wall structures such as to form a coating from the powdery substance for increasing the wall friction.

10. Dosing device according to claim 9, **characterised in that** an inner wall structure is provided which is configured in the form of a screw thread.

11. Dosing device according to claim 10, **characterised in that,** in order to form a coating from the powdery substance which increases the wall friction, the conveying channel is configured from the outlet in the direction towards the conveying channel mouth, in at least one section, as having a continuously enlarging cross-section surface, as a result of which the radial distance interval to the screw conveyor increases.

12. Dosing device according to any one of claims 1 to 11, **characterised in that** this part of a CVD system is a CVD reactor (2) connected to a carrier gas supply and a vacuum pump, and that the switching valve (22) integrated into the carrier gas line (14) is connected to a control device of the CVD system (1) for the purpose of actuation and control.

13. Dosing device according to claim 12, **characterised in that** the CVD system comprises, in addition to the dosing device, a plurality of further dosing devices connected to the CVD reactor, with different powdery substances.

14. Method for operating a dosing device (5) according to claim 1, **characterised in that,** as a result of its connection to the CVD reactor (2) of the CVD system (1), the same pressure, or only a slightly higher pressure, prevails in the storage container (6) when its dosing device is in operation than in the CVD reactor (2), and that, in order to loosen the substance present in the storage container (6), the internal pressure in the storage container (6) is intermittently increased and then reduced again spontaneously or semi-spontaneously.

15. Method according to claim 14, **characterised in that** the increase in the internal pressure in the storage container (6) is incurred by introducing carrier gas from the CVD system (1), while at the same time the delivery of carrier gas into the CVD reactor (2) is interrupted, and that the consequent pressure reduction is incurred by opening the carrier gas delivery into the reactor (2).

## Revendications

1. Dispositif de dosage permettant de doser une substance pulvérulente, notamment un précurseur afin que celui-ci soit acheminée dans un réacteur CVD (2) d'une installation CVD (1) afin de séparer une couche métallique, par exemple, d'un substrat, comprenant un réservoir (6) destiné à stocker la substance pulvérulente avec un écoulement (8), un convoyeur à vis (12) disposé sous l'écoulement (8), dans un conduit de transport (11), avec un sens de convoyage perpendiculaire au sens d'écoulement du réservoir (6) afin d'acheminer la substance pulvérulente depuis l'écoulement (8) vers une embouchure (20) dans laquelle la substance pulvérulente acheminée est absorbée en tant que charge en suspension par un flux de gaz porteur qui passe devant l'embouchure (20) et comprenant un approvisionnement en gaz porteur avec une conduite de gaz porteur (14) raccordable à une source de gaz de transport, conduite qui passe devant l'embouchure (20) du conduit de transport (11) ou qui devient une prolongation de ce dernier et raccordable à un réacteur CVD (2), **caractérisé en ce qu'**une conduite de ventilation (18) est raccordée par sa première extrémité sur la conduite de gaz porteur (14), dans le sens de circulation du gaz porteur, avant de passer l'entrée des particules de substance pulvérulente acheminées à travers l'embouchure (20) du conduit de transport (11), laquelle conduite de ventilation (18) est raccordée par son autre extrémité avec l'intérieur du réservoir (6) avec une liaison de fluides et **en ce qu'**une soupape de commande (22) est montée sur le tronçon de la conduite de gaz porteur (14) situé entre l'embouchure (21) de la conduite de ventilation (18) et l'entrée des particules de substance pulvérulente acheminées à travers l'embouchure (20) du conduit de transport (11).

2. Dispositif de dosage selon la revendication 1, **caractérisé en ce que** la conduite de ventilation (18) débouche dans le réservoir (6) au niveau de l'extrémité opposée de l'écoulement (8) de ce dernier.

3. Dispositif de dosage selon la revendication 1 ou 2, **caractérisé en ce que** la conduite de ventilation (18) est séparée de la substance pulvérulente se trouvant dans le réservoir (6) par un filtre.

4. Dispositif de dosage selon l'une des revendications 1 à 3, **caractérisé en ce que** la soupape de commande (22) est une soupape ouvert-fermé.

5. Dispositif de dosage selon l'une des revendications 1 à 4, **caractérisé en ce que** l'embouchure (20) du conduit de transport (11) est conformé avec un rétrécissement.

6. Dispositif de dosage selon l'une des revendications 1 à 5, **caractérisé en ce que** le réservoir (6) est un conteneur cylindrique debout, dont l'écoulement (8) se trouve au plus bas et dont l'ouverture supérieure est fermée de manière étanche par un élément de fermeture (7).

7. Dispositif de dosage selon l'une des revendications 1 à 6, **caractérisé en ce qu'**est disposé dans le réservoir (6), au moins un outil mélangeur (23) entraîné de manière rotative pour décompacter la substance pulvérulente stockée dans celui-ci, dont l'arbre d'entraînement (24) suit l'étendue longitudinale du réservoir (6) et qui s'étend de manière étanche avec un tronçon d'entraînement ou un tronçon de couplage (26) en traversant l'élément de fermeture (7) et qui est raccordé à un moteur rotatif disposé à l'extérieur par rapport à l'étanchéité.

8. Dispositif de dosage selon l'une des revendications 1 à 7, **caractérisé en ce que,** dans la zone de l'écoulement (8), à côté ou à l'opposé de celui-ci, au moins une roue dentée de nettoyage (29), logée de manière rotative, s'engrène dans le convoyeur à vis (12).

9. Dispositif de dosage selon la revendication 8, **caractérisé en ce que** le conduit de transport (11) présente une ou plusieurs structures de paroi intérieure afin de réaliser un revêtement à partir de la substance pulvérulente qui augmentera le frottement contre la paroi.

10. Dispositif de dosage selon la revendication 9, **caractérisé en ce que,** en guise de structure intérieure de paroi, il est prévu une structure intérieure de paroi en forme de filetage.

11. Dispositif de dosage selon la revendication 10, **caractérisé en ce que** le conduit de transport, afin de réaliser un revêtement à partir de la substance pulvérulente qui augmentera le frottement contre la paroi, est conformé depuis l'écoulement, en direction de l'embouchure du conduit de transport, au moins dans un tronçon, avec une surface de section qui s'agrandit progressivement, ce qui a pour effet d'agrandir l'intervalle radial avec le convoyeur à vis.

12. Dispositif de dosage selon l'une des revendications 1 à 11, **caractérisé en ce que** celui-ci fait partie d'une installation CVD comportant un réacteur CVD (2) raccordé à un approvisionnement de gaz porteur et une pompe à vide et **en ce que** la soupape de commande (22) intégrée dans la conduite de gaz porteur (14) est raccordée, à des fins de pilotage à une commande de l'installation CVD (1).

13. Dispositif de dosage selon la revendication 12, **caractérisé en ce que** l'installation CVD présente, en plus du dispositif de dosage, plusieurs autres dispositifs de dosage raccordés au réacteur CVD avec différentes substances pulvérulentes.

14. Procédé pour faire fonctionner un dispositif de dosage selon la revendication 1, **caractérisé en ce qu'**il règne dans le réservoir (6), à la suite de son raccordement au réacteur CVD (2) de l'installation CVD (1), lors du fonctionnement du dispositif de dosage (5), une pression identique ou très légèrement supérieure par rapport à celle dans le réacteur CVD (2) et **en ce que**, pour décompacter la substance se trouvant dans le réservoir (6), la pression interne du réservoir (6) est augmentée par intermittence et par la suite à nouveau abaissée spontanément ou quasi-spontanément.

15. Procédé selon la revendication 14, **caractérisé en ce que** la hausse de la pression interne dans le réservoir (6) est obtenue en introduisant le gaz porteur acheminé par l'installation CVD (1), tandis que l'arrivée de gaz porteur dans le réacteur CVD (2) est simultanément interrompue et **en ce que** la baisse de pression qui s'ensuit est obtenue en ouvrant l'arrivée de gaz porteur dans le réacteur (2).
